## Europäisches Patentamt

## European Patent Office

## Office européen des brevets

(19)

(11) Veröffentlichungsnummer: **0 023 694**
**A1**

(12)

# EUROPÄISCHE PATENTANMELDUNG

(21) Anmeldenummer: **80104433.0**

(22) Anmeldetag: **28.07.80**

(51) Int. Cl.³: **H 05 K 5/04**

(30) Priorität: **06.08.79 DE 7922430 U**

(43) Veröffentlichungstag der Anmeldung: **11.02.81**
**Patentblatt 81/6**

(84) Benannte Vertragsstaaten: **AT BE CH FR GB IT LI LU NL SE**

(71) Anmelder: **SIEMENS AKTIENGESELLSCHAFT Berlin und München, Postfach 22 02 61, D-8000 München 22 (DE)**

(72) Erfinder: **Heinzel, Günter, Hansastrasse 128, D-8000 München 70 (DE)**

(54) **Baugruppenträger für elektrische Steckbaugruppen.**

(57) Baugruppenträger mit einem aus vier Seitenblechen gebildeten rechteckigen Rahmen mit Steckbaugruppen, der mit einer Rückwand, die eine mit Steckern versehene Leiterplatte ist, lösbar verbunden wird. Die Seitenbleche weisen mit Hinterschneidungen versehene Haltelappen auf, die in entsprechende Durchbrüche der Leiterplatte eingesteckt werden und durch eine Parallelverschiebung der Leiterplatte mit dieser formschlüssig in Eingriff gebracht werden. Im Frontbereich sind zwei gegenüberliegende Seitenbelche abgewinkelt und mit Durchbrüchen versehen. Damit wird der Baugruppenträger im Gestellrahmen befestigt. An solchen weiteren Durchbrüchen wird die Frontplatte befestigt, die gleichzeitig die Steckbaugruppen verriegelt. Ein weiteres Arretiermittel verriegelt den Einschubrahmen mit der Leiterplatte.

SIEMENS AKTIENGESELLSCHAFT     Unser Zeichen:
Berlin und München            VPA
                                   79 P 2 3 6 0 EUR

Baugruppenträger für elektrische Steckbaugruppen
--------------------------------------------------------------

Die Erfindung ~~Neuerung~~ bezieht sich auf einen Baugruppenträger
mit einem aus vier Seitenblechen gebildeten rechteckigen Einschubrahmen für Steckbaugruppen und mit einem
die Rückwand des Einschubrahmens bildenden, mit den
Seitenblechen lösbar verbundenen sowie Steckerelemente
für die Steckbaugruppen tragenden Leiterplatte. Derartige elektrische Steckbaugruppen wurden bereits
bisher in mehrere Führungselemente aufweisende Einschubrahmen eingeschoben und über an der Rückwand angebrachte Steckerelemente elektrisch verbunden. Beispielsweise ist aus dem Gebrauchsmuster 75 30 408 ein derartiger Baugruppenträger für den Einschub von Steckbaugruppen bekannt. Diese Baugruppenträger werden wie
eine Kassette in die dafür vorgesehenen Gestellrahmen
eingeschoben.

En 1 Wt / 3.8.1979

Da bei solchen Steckbaugruppen derzeit die Steckerelemente immer häufiger auf der Rückseite einer Trägerleiterplatte aufgeschwallt sind, besteht leicht die Gefahr des Bruches, wenn die beim Stecken und Ziehen der Steckbaugruppe entstehenden Druck- und Zugkräfte von der Haltevorrichtung des Baugruppenträgers nicht aufgefangen werden.

Bisher wurden die Befestigungswinkel aufweisenden Seitenbleche mit der Rückwand des Baugruppenträgers verbunden, beispielsweise mit mehreren Schrauben. Dies erfordert, je nach Stabilität, eine gewisse Anzahl an Schrauben mit entsprechenden Gewinden in der Baugruppenträgerrückwand. Diese Art Befestigung war technisch aufwendig und teuer.

Aufgabe der Erfindung ~~Neuerung~~ ist es, einen stabilen Baugruppenträger zu schaffen, dessen Seitenbleche ohne großen mechanischen Mehraufwand mit der Rückwand stabil verbunden sind. Dies wird erfindungs~~neuerungs~~gemäß dadurch erreicht, daß zumindest an zwei einander gegenüberliegenden Seitenblechen des Einschubrahmens der Leiterplatte zugewandte, mit Hinterschneidungen versehene Haltelappen vorgesehen sind, welche in entsprechende Durchbrüche der Leiterplatte eingesteckt und durch eine zur Leiterplattenebene parallele Verschiebung des Einschubrahmens jeweils aufgrund ihrer Hinterschneidungen den Rand der Durchbrüche umfassend mit der Leiterplatte formschlüssig in Eingriff gebracht sind, wobei der Einschubrahmen einerseits und die Leiterplatte andererseits durch ein weiteres Arretiermittel gegeneinander verriegelbar sind.

Die Leiterplatte des Baugruppenträgers weist eine der gewünschten Stabilität entsprechende Anzahl von Durchbrüchen auf, die beispielsweise ausgestanzt sein können. An der der Leiterplatte zugewandten Seite der Seitenbleche, die zueinander im rechten Winkel befestigt sind, sind entsprechend der Anzahl der Durchbrüche der Leiterplatte Haltelappen mit Hinterschneidungen angeordnet. Sie sind so ausgeformt, daß sich der Einschubrahmen nach dem Einstecken in die Durchbrüche parallel zur Leiterplattenebene verschieben läßt. Aufgrund der Hinterschneidungen wird der Einschubrahmen mit der Leiterplatte formschlüssig in Eingriff gebracht, wobei die Hinterschneidungen den Rand der Durchbrüche umfassen. Durch ein weiteres Arretiermittel, das eine Schraube sein kann, sind der Einschubrahmen und die Leiterplatte gegeneinander verriegelbar.

In vorteilhafter Weise sieht man zumindest an zwei gegenüberliegenden Seitenflächen Ansätze vor, die ein definiertes Auflager für die Leiterplatte darstellen.

Zweckmäßigerweise sind die Hinterschneidungen der Haltelappen so ausgeformt, daß sie der Dicke der Leiterplatte entsprechen.

Zur weiteren Erhöhung der Stabilität des Baugruppenträgers können an einem oder mehreren Seitenblechen T-förmige Haltelappen angeformt sein, die mit ebenfalls T-förmigen Durchbrüchen in der Leiterplatte in Eingriff gebracht werden.

Eine vorteilhafte Weiterbildung der ~~Neuerung~~ Erfindung stellt die an der Frontseite abgewinkelten Seitenbleche mit Durchbrüchen zur Befestigung im Gestellrahmen dar. Der Gestellrahmen weist an den entsprechenden Stellen ebenfalls Durchbrüche auf, die mit einem Gewinde versehen sein können, so daß der Baugruppenträger im Gestell angeschraubt werden kann.

Zweckmäßigerweise sieht man an diesen abgewinkelten
Seitenblechen beispielsweise in der Mitte jeweils
einen weiteren Durchbruch zur Befestigung der Frontplatte vor. Diese Frontplatte kann mit fensterähnlichen
Aussparungen für die Anzeige und/oder Bedienungselemente
der Steckbaugruppen versehen sein. Mit der Befestigung
der Frontplatte an dem abgewinkelten Seitenblech, beispielsweise mit Schrauben, bewirkt man gleichzeitig eine
feste Verriegelung aller Steckbaugruppen.

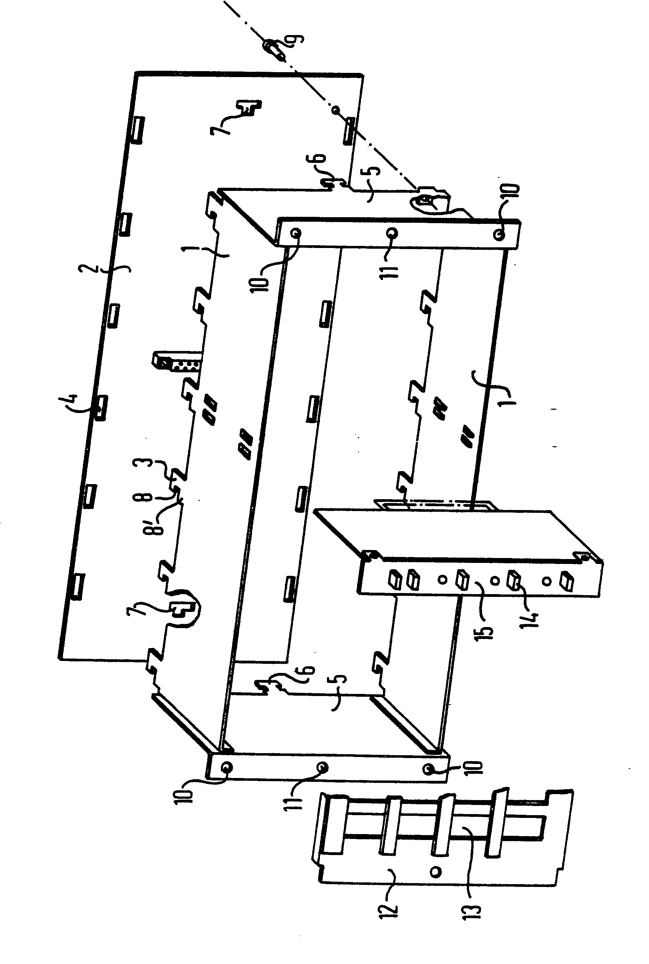

Weitere Einzelheiten der ~~Neuerung~~ Erfindung ergeben sich aus einem
in der Zeichnung dargestellten Ausführungsbeispiel.

Die einzige Figur zeigt in Explosionsdarstellung einen
~~neuerungs~~ erfindungsgemäßen Baugruppenträger.

Die gegenüberliegenden Seitenbleche 1 weisen eine bestimmte Anzahl L-förmiger Haltelappen 3 mit Hinterschneidungen 8 auf. Die Anzahl richtet sich nach der
Größe des Baugruppenträgers und nach der gewünschten
Stabilität. Das linke und rechte Seitenblech 5 besitzt
je einen T-förmigen Haltelappen 6, um Zug- und Druckkräfte auch auf der Höhe der Seitenbleche 5 abzufangen.
Die Leiterplatte 2 des Baugruppenträgers ist entsprechend der Anzahl der Haltelappen 3 der Seitenbleche 1 mit rechteckigen Durchbrüchen 4 versehen. Für
die Aufnahme der Haltelappen 6 des linken und rechten
Seitenblechs 5 weist die Leiterplatte 2 je einen T-
förmigen Durchbruch 7 auf. Alle Haltelappen 3 und 6
sind derart ausgebildet, daß die entsprechend mit
Durchbrüchen 4 und 7 versehene Leiterplatte 2 des
Baugruppenträgers beim Durchstecken aller Haltelappen
3 und 6 an den Ansätzen 8' der Seitenbleche eine definierte Auflage erhält. Durch paralleles Verschieben
des Einschubrahmens zur Leiterplatte 2 ergibt sich eine stabile Verbindung zwischen der Leiterplatte 2 und den
Seitenblechen 1 und 5 des Baugruppenträgers. Mit nur
einer Schraube 9 wird der Baugruppenträger fixiert und
somit am seitlichen Herausrutschen gehindert.

Die Seitenbleche 5 sind an der Frontseite abgewinkelt und
weisen je drei Durchbrüche auf. Die Durchbrüche 1o sind
oben und unten angebracht und dienen zur Befestigung im
Gestellrahmen. Die mittig angebrachten Durchbrüche 11
dienen zur Befestigung der Frontplatte 12, die mit fensterähnlichen Aussparungen 13 versehen ist, die die Bedien-
und Anzeigeelemente 14 der dahinterliegenden Steckbaugruppen 15 freilassen. Gleichzeitig wird mit der Frontplatte 12 eine feste Verriegelung der Steckbaugruppen 15
erreicht.

1 Figur
6 ~~Schutz~~Patentansprüche

Patent
~~Schutz~~ansprüche:

1. Baugruppenträger mit einem aus vier Seitenblechen gebildeten rechteckigen Einschubrahmen für Steckbaugruppen und mit einem die Rückwand des Einschubrahmens bildenden, mit den Seitenblechen lösbar verbundenen sowie Steckerelemente für die Steckbaugruppen tragenden Leiterplatte, d a d u r c h   g e k e n n z e i c h n e t, daß zumindest an zwei einander gegenüberliegenden Seitenblechen (1; 5) des Einschubrahmens der Leiterplatte (2) zugewandte, mit Hinterschneidungen (8) versehene Haltelappen (3,6) vorgesehen sind, welche in entsprechende Durchbrüche (4,7) der Leiterplatte (2) eingesteckt und durch eine zur Leiterplattenebene parallele Verschiebung des Einschubrahmens jeweils aufgrund ihrer Hinterschneidungen (8) den Rand der Durchbrüche (4,7) umfassend mit der Leiterplatte (2) formschlüssig in Eingriff gebracht sind, wobei der Einschubrahmen einerseits und die Leiterplatte (2) andererseits durch ein weiteres Arretiermittel (9) gegeneinander verriegelbar sind.

2. Baugruppenträger nach Anspruch 1, d a d u r c h   g e k e n n z e i c h n e t, daß an mindestens zwei einander gegenüberliegenden Seitenblechen (1,5) Ansätze (8') als definiertes Auflager für die Leiterplatte (2) vorgesehen sind.

3. Baugruppenträger nach Anspruch 1 oder 2, dadurch g e k e n n z e i c h n e t, daß die Hinterschneidungen (8) der Haltelappen (3,6) genau der Dicke der Leiterplatte (2) angepaßt sind.
En 1 Wt / 3.8.79

4. Baugruppenträger nach einem der Ansprüche 1 bis 3, dadurch g e k e n n z e i c h n e t, daß an einem oder mehreren der Seitenbleche (5) T-förmige Haltelappen (6) angeformt und mit ebenfalls T-förmigen Durchbrüchen (7) der Leiterplatte (2) in Eingriff gebracht sind.

5. Baugruppenträger nach einem der Ansprüche 1 bis 4, dadurch g e k e n n z e i c h n e t, daß zwei einander gegenüberliegende Seitenbleche (5) im Frontbereich abgewinkelt sind und mit Durchbrüchen (10) zur Befestigung im Gestellrahmen versehen sind.

6. Baugruppenträger nach einem der Ansprüche 1 bis 5, dadurch g e k e n n z e i c h n e t, daß zwei einander gegenüberliegende, im Frontbereich abgewinkelte Seitebleche (5) mit je einem weiteren Durchbruch (11) zur Befestigung der Frontplatte (12) versehen sind, wobei die Frontplatte (12) gleichzeitig alle Steckbaugruppen (15) verriegelt.

0023694

Nummer der Anmeldung
EP 80 10 ....

# EUROPÄISCHER RECHERCHENBERICHT

**Europäisches Patentamt**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| D,A | DE - U - 7 530 408 (SIEMENS)<br>* Zusammenfassung * | 4 |
| | DE - A - 2 703 889 (SIEMENS)<br>* Seiten 4,5 * | 1,3 |
| P | DE - U - 7 922 430 (SIEMENS)<br>* Zusammenfassung * | 1-6 |

**KLASSIFIKATION DER ANMELDUNG (Int. Cl.³)**

H 05 K 5/04

**RECHERCHIERTE SACHGEBIETE (Int. Cl.³)**

H 05 K 5/04
H 02 B 1/08

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 03-11-1980 | DA'L.... |

EPA form 1503.1   06.78